# EUROPEAN PATENT APPLICATION

(11) **EP 3 876 294 A1**
(43) Date of publication of application: **08.09.2021**
(21) Application number: 19880003.9
(22) Date of filing: 01.11.2019
(51) Int. Cl.: H01L 33/62, H01L 33/38, H01L 33/24, H01L 27/15

(54) **LIGHT-EMITTING DIODE**

(30) Priority: 02.11.2018 US 201862754733 P; 30.10.2019 US 201916668325
(71) Applicant: Seoul Viosys Co., Ltd, Ansan-si, Gyeonggi-do 15429 (KR)
(72) Inventor: JANG, Seong Kyu, Ansan-si Gyeonggi-do 15429 (KR); SHIN, Chan Seob, Ansan-si Gyeonggi-do 15429 (KR); LEE, Seom Geun, Ansan-si Gyeonggi-do 15429 (KR); LEE, Ho Joon, Ansan-si Gyeonggi-do 15429 (KR); CHAE, Jong Hyeon, Ansan-si Gyeonggi-do 15429 (KR)
(74) Representative: Stolmár & Partner Patentanwälte PartG mbB
(86) International application number: PCT/KR2019/014710
(87) International publication number: WO 2020/091507

(57) **Abstract**

A light-emitting diode is provided. A light-emitting diode comprises: a first light-emitting unit comprising a 1-1 type semiconductor layer, a first active layer and a 1-2 type semiconductor layer; a second light-emitting unit disposed on the first light-emitting unit and comprising a 2-1 type semiconductor layer, a second active layer and a 2-2 type semiconductor layer; a third light-emitting unit disposed on the second light-emitting unit and comprising a 3-1 type semiconductor layer, a third active layer and a 3-2 type semiconductor layer; a first conductive pattern comprising a first part, which is disposed inside the second light-emitting unit and is electrically connected to at least one of the 1-1 type, 1-2 type, 2-1 type and 2-2 type semiconductor layers, and a second part which extends from the first part to one surface of the second light-emitting unit between the second and third light-emitting units; and a second conductive pattern which is disposed on the third light-emitting unit and is electrically connected to the first conductive pattern, wherein the second conductive pattern comprises an area which at least partly overlaps the second part of the first conductive pattern.

## Description

### [Technical field]

The disclosure relates to a light emitting device, and more particularly, to a light emitting device in which a plurality of light emitting layers are stacked.

### [Related art]

Light emitting diodes as inorganic light sources are being diversely used in various fields such as display devices, vehicle lamps and general lighting. Light emitting diodes are rapidly replacing existing light sources due to their longer lifetime, lower power consumption, and faster response speed than existing light sources.

In particular, a display device generally implements various colors by utilizing mixed colors of blue, green and red. Each pixel of a display device includes blue, green and red sub pixels, the color of a particular pixel is determined through the colors of these sub pixels, and an image is implemented by a combination of pixels.

Light emitting diodes have been mainly used as backlight sources in display devices. However, recently, a micro LED display has been developed as a next generation display which directly implements images by using light emitting diodes.

### [DISCLOSURE]

### [Technical Problem]

The invention is directed to a light emitting device which is improved in light efficiency.

An object to be achieved by the disclosure is not limited to the aforementioned objects, and those skilled in the art to which the disclosure pertains may clearly understand other objects from the following descriptions.

### [Technical Solution]

A light emitting device according to embodiments of the invention for solving the technical problem may include: a first light emitting part including a first first-type semiconductor layer, a first active layer and a first second-type semiconductor layer; a second light emitting part disposed over the first light emitting part, and including a second first-type semiconductor layer, a second active layer and a second second-type semiconductor layer; a third light emitting part disposed over the second light emitting part, and including a third first-type semiconductor layer, a third active layer and a third second-type semiconductor layer; a first conductive pattern including a first portion which is disposed in the second light emitting part and is electrically coupled with at least one among the first first-type, first second-type, second first-type and second second-type semiconductor layers, and a second portion which extends from the first portion to one surface of the second light emitting part between the second and third light emitting parts; and a second conductive pattern disposed in the third light emitting part, and electrically coupled with the first conductive pattern, wherein the second conductive pattern includes an area which overlaps at least partially with the second portion of the first conductive pattern.

According to embodiments, the second light emitting part may have a via hole passing through at least a portion of the second light emitting part; and the first portion of the first conductive pattern may be formed along the via hole, and an inside of the via hole may be filled with an insulating material.

According to embodiments, the third light emitting part may have a via hole passing through the third light emitting part; the second conductive pattern may include a first portion which is formed along the via hole of the third light emitting part, and a second portion which extends from the first portion to one surface of the third light emitting part; and the second portion of the first conductive pattern and the first portion of the second conductive pattern may partially overlap with each other.

According to embodiments, the first portion of the first conductive pattern and the first portion of the second conductive pattern may have the same width.

According to embodiments, the light emitting device may further include a pad electrically coupled with the second portion of the second conductive pattern.

According to embodiments, the second light emitting part may have a via hole passing through at least a portion of the second light emitting part, and the first portion of the first conductive pattern may fill the via hole.

According to embodiments, the third light emitting part may have a via hole passing through the third light emitting part; the second conductive pattern may include a first portion which fills the via hole of the third light emitting part, and a second portion which extends from the first portion onto one surface of the third light emitting part; and the second portion of the first conductive pattern and the first portion of the second conductive pattern may include at least partial areas which overlap with each other.

According to embodiments, the first portion of the first conductive pattern and the first portion of the second conductive pattern may have the same width.

According to embodiments, the light emitting device may further include a pad electrically coupled with the second portion of the second conductive pattern.

According to embodiments, the first portion of the first conductive pattern may be electrically coupled with the first first-type semiconductor layer, and the second portion may be electrically coupled with the second first-type semiconductor layer on the one surface of the second light emitting part; and the second conductive pattern may include a first portion which is electrically coupled with the second portion of the first conductive pattern, and a second portion which extends from the first portion of the second conductive pattern and is electrically coupled with the third first-type semiconductor layer.

According to embodiments, the first portion of the first conductive pattern may be electrically coupled with the first second-type semiconductor layer; and the second conductive pattern may include a first portion which is electrically coupled with the second portion of the first conductive pattern, and a second portion which extends from the first portion of the second conductive pattern to one surface of the third light emitting part.

According to embodiments, the first portion of the first conductive pattern may be electrically coupled with the second second-type semiconductor layer; and the second conductive pattern may include a first portion which is electrically coupled with the second portion of the first conductive pattern, and a second portion which extends from the first portion of the second conductive pattern to one surface of the third light emitting part.

According to embodiments, the light emitting device may further include a third conductive pattern electrically coupled with the third second-type semiconductor layer.

According to embodiments, the third light emitting part may have a via hole passing through at least a portion of the third light emitting part; and the third conductive pattern may include a first portion which is disposed along the via hole, and a second portion which extends from the first portion to one surface of the third light emitting part.

According to embodiments, the light emitting device may further include a pad electrically coupled with the second portion of the third conductive pattern.

According to embodiments, the third light emitting part may have a via hole passing through at least a portion of the third light emitting part; and the third conductive pattern may include a first portion which fills the via hole, and a second portion which extends from the first portion to one surface of the third light emitting part.

According to embodiments, each of the first to third light emitting parts may have an inclined outer sidewall.

According to embodiments, may further include an insulating layer disposed between the first portion of the first conductive pattern and a side surface of the second light emitting part.

According to embodiments, the insulating layer may extend to an outer sidewall of the second light emitting part.

According to embodiments, the light emitting device may further include a first adhesion part bonding the first and second light emitting parts; and a second adhesion part bonding the second and third light emitting parts, wherein the first adhesion part may extend to an outer sidewall of the first light emitting part, and wherein the second adhesion part may extend to an outer sidewall of the second light emitting part.

According to embodiments, the light emitting device may further include an insulating layer extending to an outer sidewall of the first portion of the first conductive pattern and an outer sidewall of the second light emitting part, wherein the insulating layer may be disposed between the second light emitting part and the second adhesion part.

According to embodiments, each of the first and second light emitting parts may have an inclined outer sidewall; the first adhesion part may have a width that increases from the first light emitting part toward the second light emitting part; and the second adhesion part may have a width that increases from the second light emitting part toward the third light emitting part.

The details of other embodiments are included in the detailed description and the drawings.

### [Advantageous effects]

In the light emitting device in accordance with embodiments of the disclosure, by forming via holes in each of a plurality of light emitting parts and forming conductive patterns which at least partially fill the via holes and extend to portions of each light emitting part, it is possible to electrically couple conductive patterns with a first pad, a second pad, a third pad and a common pad more stably than when via holes are formed at a time after all light emitting parts are stacked.

Further, since each of the plurality of light emitting parts is isolated while forming via holes, a tensile stress to be applied to a substrate may be mitigated.

### [Description of Drawings]

FIG. 1a is a representation of an example of a top view to assist in the explanation of a light emitting device in accordance with an embodiment of the disclosure.

FIGS. 1b and 1c are cross-sectional views taken along the line A-A' of FIG. 1a.

FIGS. 2 to 16 are representations of examples of cross-sectional views to assist in the explanation of a method for manufacturing a light emitting device in accordance with an embodiment of the disclosure.

FIGS. 17 and 18 are representations of examples of cross-sectional views to assist in the explanation of a method for mounting light emitting devices to a mounting board in accordance with an embodiment of the disclosure.

### [Best Mode]

In order to understand the configuration and effect of the disclosure sufficiently, embodiments of the disclosure will be described with reference to the accompanying drawings. However, the disclosure is not limited to the embodiments set forth herein and may be implemented in various forms, and a variety of changes may be added.

As used in the embodiments of the disclosure, a technical term may be interpreted as a meaning conventionally known to those of ordinary skill in the art unless defined otherwise.

Hereinafter, a light emitting device will be described below with reference to the accompanying drawings through various examples of embodiments.

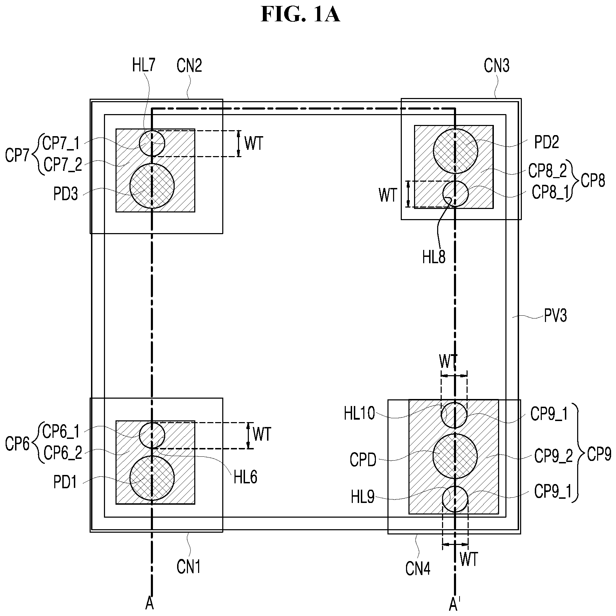

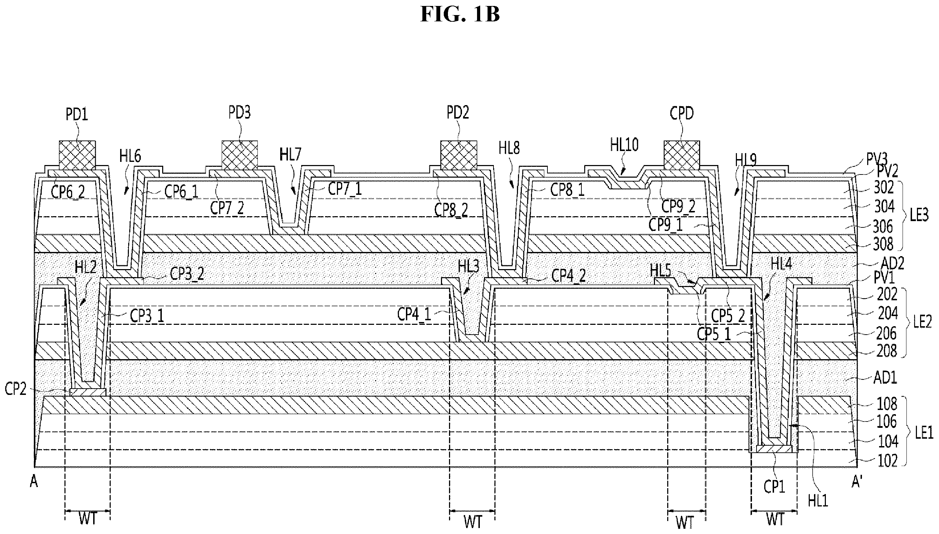

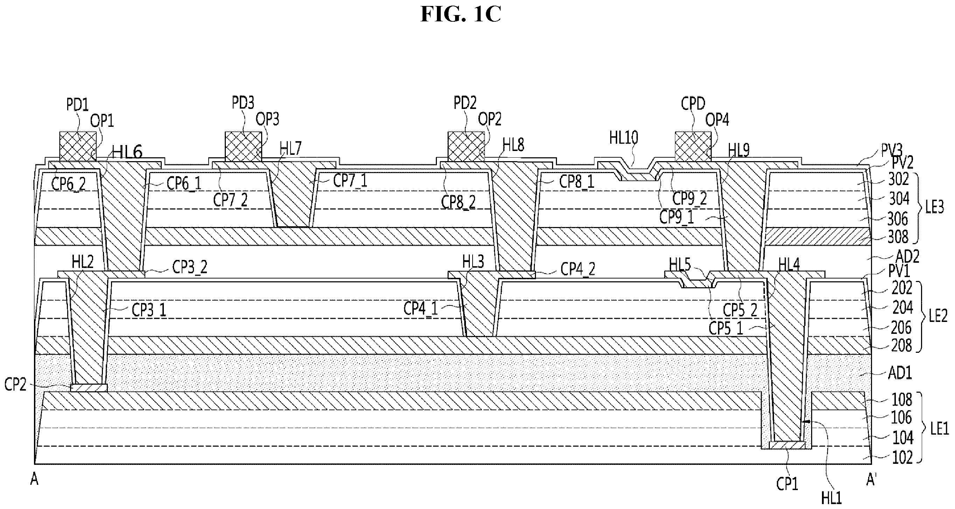

FIG. 1a is a representation of an example of a top view to assist in the explanation of a light emitting device in accordance with an embodiment of the disclosure, and FIGS. 1b and 1c are cross-sectional views taken along the line A-A' of FIG. 1a.

Referring to FIGS. 1a to 1c, a light emitting device may include a first light emitting part LE1, a second light emitting part LE2 and a third light emitting part LE3.

One surface of the first light emitting part LE1 may face the second light emitting part LE2, and the other, opposing surface of the first light emitting part LE1 facing away from the one surface may be the light extraction surface of the light emitting device. In this case where the other surface of the first light emitting part LE1 is the light extraction surface, the wavelength of the light emitted from the first light emitting part LE1 may be the shortest, the wavelength of the light emitted from the second light emitting part LE2 may be longer than the wavelength of the light emitted from the first light emitting part LE1 and be shorter than the wavelength of the light emitted from the third light emitting part LE3, and the wavelength of the light emitted from the third light emitting part LE3 may be the longest. For example, the first light emitting part LE1 may emit blue light, the second light emitting part LE2 may emit green light, and the third light emitting part LE3 may emit red light.

In an embodiment of the invention, the first light emitting part LE1 and the second light emitting part LE2 may be stacked in different order from those described above. For example, in the above-described embodiment, the second light emitting part LE2 is stacked on the first light emitting part LE1, however the first light emitting part LE1 may be stacked on the second light emitting part LE2 in this embodiment. In this case, one surface of the second light emitting part LE2 may face the first light emitting part LE1, and the other, opposing surface of the second light emitting part LE2 opposite to the surface of the second light emitting part LE2 may be a light extraction surface of the light emitting device.

The first light emitting part LE1 may include a first n-type semiconductor layer 102, a first active layer 104, a first p-type semiconductor layer 106 and a first ohmic layer 108 which are vertically stacked. The second light emitting part LE2 may include a second ohmic layer 208, a second p-type semiconductor layer 206, a second active layer 204 and a second n-type semiconductor layer 202 which are vertically stacked. The third light emitting part LE3 may include a third ohmic layer 308, a third p-type semiconductor layer 306, a third active layer 304 and a third n-type semiconductor layer 302 which are vertically stacked.

Each of the first n-type semiconductor layer 102, the second n-type semiconductor layer 202 and the third n-type semiconductor layer 302 may be a Si-doped gallium nitride-based semiconductor layer. Each of the first p-type semiconductor layer 106, the second p-type semiconductor layer 206 and the third p-type semiconductor layer 306 may be a Mg-doped gallium nitride-based semiconductor layer. Each of the first active layer 104, the second active layer 204 and the third active layer 304 may include a multi-quantum well (MQW), and the composition ratio thereof may be determined to emit light of a desired peak wavelength. As each of the first ohmic layer 108, the second ohmic layer 208 and the third ohmic layer 308, a transparent conductive oxide (TCO) such as zinc oxide (ZnO), indium oxide (InO₂), tin oxide (SnO), indium tin zinc oxide (ITZO), and indium tin oxide (ITO) may be used. Or, as each of the first ohmic layer 108, the second ohmic layer 208 and the third ohmic layer 308, a metal ohmic layer formed of a metal such as Al, Ti, Cr, Ni, Au, Ag, Sn, W, Cu, or an alloy thereof may be used, without being limited thereto. The alloy of the metal may be an alloy of Au-Be, Au-Te or Au-Ge. According to an embodiment, the first light emitting part LE1 may have a first hole HL1 which exposes the first n-type semiconductor layer 102. For instance, the first hole HL1 may have a vertical side surface. For another instance, the first hole HL1 may have an inclined side surface.

The light emitting device may further include a first conductive pattern CP1 which is brought into electrical contact with the first n-type semiconductor layer 102 exposed by the first hole HL1 of the first light emitting part LE1 and a second conductive pattern CP2 which is brought into electrical contact with the first ohmic layer 108. Each of the first conductive pattern CP1 and the second conductive pattern CP2 may include at least one selected from the group consisting of Au, Ag, Ni, Al, Rh, Pd, Ir, Ru, Mg, Zn, Pt, Hf, Cr, Ti and Cu. Further, each of the first conductive pattern CP1 and the second conductive pattern CP2 may include an alloy thereof. Selectively, the first conductive pattern CP1 and the second conductive pattern CP2 may be omitted.

The first light emitting part LE1 may be disposed by being separated from the second light emitting part LE2. For instance, the first ohmic layer 108 of the first light emitting part LE1 and the second ohmic layer 208 of the second light emitting part LE2 may be disposed to face each other. For another instance, the first ohmic layer 108 of the first light emitting part LE1 and the second n-type semiconductor layer 202 of the second light emitting part LE2 may be disposed to face each other.

The light emitting device may further include a first adhesion part AD1 which bonds the first light emitting part LE1 and the second light emitting part LE2, between the first light emitting part LE1 and the second light emitting part LE2 separated from each other. The first adhesion part AD1 may be transparent and have an insulating property and an adhesion property. The first adhesion part AD1 may include glass, a polymer, a resist or a polyimide. For example, the first adhesion part AD1 may include SOG (spin-on-glass), BCB (benzo cyclo butadiene), HSQ (hydrogen silsesquioxanes), PMMA (polymethylmethacrylate), parylene,an SU-8 photoresist, or etc. According to an embodiment, the first adhesion part AD1 may be disposed while filling the first hole HL1 of the first light emitting part LE1.

According to an embodiment, the first light emitting part LE1 may have an inclined side surface such that it has a wider width in a downward direction. That is to say, the first n-type semiconductor layer 102 of the first light emitting part LE1 may have a larger width than the first ohmic layer 108, the first ohmic layer 108 may have a larger width than the first p-type semiconductor layer 106, and the first p-type semiconductor layer 106 may have a larger width than the first ohmic layer 108. The first adhesion part AD1 may extend to surround the outer sidewall of the first light emitting part LE1.

Selectively, the light emitting device may further include a first color filter which is disposed between the first light emitting part LE1 and the second light emitting part LE2. For instance, the first color filter may be disposed on the first ohmic layer 108 of the first light emitting part LE1. For another instance, the first color filter may be disposed on the second ohmic layer 208 of the second light emitting part LE2. The first color filter may reflect the light generated from the first light emitting part LE1 and pass the light generated from the second light emitting part LE2 and the third light emitting part LE3, so that the light generated from the first light emitting part LE1 does not exert an influence on each of the second light emitting part LE2 and the third light emitting part LE3. The first color filter may include a DBR (distributed Bragg reflector) having a structure in which TiO2 and SiO2 are alternately stacked.

The second light emitting part LE2 may include a second hole HL2 which passes through the second light emitting part LE2 and the first adhesion part AD1 and exposes the second conductive pattern CP2, a third hole HL3 which exposes the second ohmic layer 208 of the second light emitting part LE2, and a fourth hole HL4 which passes through the second light emitting part LE2 and the first adhesion part AD1 and exposes the first conductive pattern CP1. For instance, the second light emitting part LE2 may further include a fifth hole HL5 which exposes the second n-type semiconductor layer 202 as a portion of the second n-type semiconductor layer 202 is etched. The fifth hole HL5 may be selectively formed, and may be omitted as the case may be.

Selectively, in the case where the first conductive pattern CP1 and the second conductive pattern CP2 are omitted, the second hole HL2 may expose a portion of the first ohmic layer 108, and the fourth hole HL4 may expose a portion of the first n-type semiconductor layer 102 in the first hole HL1.

According to an embodiment, each of the second hole HL2, the third hole HL3, the fourth hole HL4 and the fifth hole HL5 may have an inclined side surface of which width gradually decreases in the downward direction. A width WT of each of the second hole HL2, the third hole HL3, the fourth hole HL4 and the fifth hole HL5 may have substantially the same size. The width WT of each hole is the largest width of the hole. For example, the width WT of each of the second hole HL2, the third hole HL3, the fourth hole HL4 and the fifth hole HL5 may be approximately 1/10 of the size of the light emitting device.

The light emitting device may further include a third conductive pattern CP3 which at least partially fills the second hole HL2, is brought into electrical contact with the second conductive pattern CP2 and extends onto the second light emitting part LE2, a fourth conductive pattern CP4 which at least partially fills the third hole HL3, is brought into electrical contact with the second ohmic layer 208 and extends onto the second light emitting part LE2, and a fifth conductive pattern CP5 which at least partially fills the fourth hole HL4 and the fifth hole HL5, is brought into electrical contact with the first conductive pattern CP1 and extends onto the second light emitting part LE2. Each of the third conductive pattern CP3, the fourth conductive pattern CP4 and the fifth conductive pattern CP5 may include at least one selected from the group consisting of Au, Ag, Ni, Al, Rh, Pd, Ir, Ru, Mg, Zn, Pt, Hf, Cr, Ti and Cu. Further, each of the third conductive pattern CP3, the fourth conductive pattern CP4 and the fifth conductive pattern CP5 may include an alloy thereof.

Selectively, in the case where the first conductive pattern CP1 and the second conductive pattern CP2 are omitted, the third conductive pattern CP3 may be brought into electrical contact with the first ohmic layer 108 exposed at the bottom of the second hole HL2, and the fifth conductive pattern CP5 may be brought into electrical contact with the first n-type semiconductor layer 102 exposed at the bottom of the fourth hole HL4.

According to an embodiment shown in FIG. 1b, the third conductive pattern CP3 may not completely fill the second hole HL2, and may be thinly and conformally formed along the inner sidewall of the second hole HL2. The third conductive pattern CP3 may include a first portion CP3_1 which is disposed in the second hole HL2 and a second portion CP3_2 which extends from the first portion CP3_1 to the top surface of the second light emitting part LE2. The fourth conductive pattern CP4 may not completely fill the third hole HL3, and may be thinly and conformally formed along the inner sidewall of the third hole HL3. The fourth conductive pattern CP4 may include a first portion CP4_1 which is disposed in the third hole HL3 and a second portion CP4_2 which extends from the first portion CP4_1 to the top surface of the second light emitting part LE2. The fifth conductive pattern CP5 may not completely fill the fourth hole HL4 and the fifth hole HL5, and may be thinly and conformally formed along the inner sidewalls of the fourth hole HL4 and the fifth hole HL5. The fifth conductive pattern CP5 may include first portions CP5_1 which are respectively disposed in the fourth hole HL4 and the fifth hole HL5 and a second portion CP5_2 which couples the first portions CP5_1 and extends from the first portions to the top surface of the second light emitting part LE2. For instance, the second portion CP5_2 of the fifth conductive pattern CP5 may be disposed between the fourth hole HL4 and the fifth hole HL5. However, it is to be noted that the disclosure is not limited thereto.

According to another embodiment shown in FIG. 1c, the third conductive pattern CP3 may include a first portion CP3_1 which fills the second hole HL2 and a second portion CP3_2 which extends from the first portion CP3_1 and extends on the top surface of the second light emitting part LE2. The fourth conductive pattern CP4 may include a first portion CP4_1 which fills the third hole HL3 and a second portion CP4_2 which extends from the first portion CP4_1 and extends on the top surface of the second light emitting part LE2. The fifth conductive pattern CP5 may include first portions CP5_1 which fill the fourth hole HL4 and the fifth hole HL5 and a second portion CP5_2 which couples the first portions CP5_1 and extends from the first portions CP5_1 to the top surface of the second light emitting part LE2.

The light emitting device may further include a first passivation layer PVT1 which surrounds the outer sidewall of the third conductive pattern CP3 between the third conductive pattern CP3 and the second hole HL2, surrounds the outer sidewall of the fourth conductive pattern CP4 between the fourth conductive pattern CP4 and the third hole HL3, surrounds the outer sidewall of the fifth conductive pattern CP5 between the fifth conductive pattern CP5 and the fourth hole HL4 and the fifth hole HL5, and extends to the top surface of the second light emitting part LE2 to insulate the third conductive pattern CP3, the fourth conductive pattern CP4 and the fifth conductive pattern CP5 from the second light emitting part LE2. The first passivation layer PV1 may include at least one selected from the group consisting of SiNx, TiNx, TiOx, TaOx, ZrOx, HfOx, AlxOy and SiOx.

According to an embodiment, the second light emitting part LE2 may have an inclined side surface such that it has a wider width in the downward direction. That is to say, the second ohmic layer 208 of the second light emitting part LE2 may be larger than the second p-type semiconductor layer 206, the second p-type semiconductor layer 206 may be larger than the second active layer 204, and the second active layer 204 may be larger than the second n-type semiconductor layer 202. A second adhesion part AD2 may extend to surround the outer sidewall of the second light emitting part LE2. The first passivation layer PV1 may be disposed between the outer sidewall of the second light emitting part LE2 and the second adhesion part AD2. In another instance, the first passivation layer PV1 may be omitted between the outer sidewall of the second light emitting part LE2 and the second adhesion part AD2.

The second light emitting part LE2 may be disposed by being separated from the third light emitting part LE3. For instance, the second n-type semiconductor layer 202 of the second light emitting part LE2 and the second ohmic layer 208 of the third light emitting part LE3 may be disposed to face each other. For another instance, the second n-type semiconductor layer 202 of the second light emitting part LE2 and the third n-type semiconductor layer 302 of the third light emitting part LE3 may be disposed to face each other.

The light emitting device may further include the second adhesion part AD2 which bonds the second light emitting part LE2 and the third light emitting part LE3, between the second light emitting part LE2 and the third light emitting part LE3 separated from each other. The second adhesion part AD2 may be transparent and have an insulating property and an adhesion property. The second adhesion part AD2 may include the same material as the first adhesion part AD1, such as glass, a polymer, a resist or a polyimide. For example, the second adhesion part AD2 may include SOG, BCB, HSQ or an SU-8 photoresist, etc. According to the embodiment shown in FIG. 1b, the second adhesion part AD2 may be disposed while filling the second hole HL2 formed with the third conductive pattern CP3, the third hole formed with the fourth conductive pattern CP4 and the fourth hole HL4 and the fifth hole HL5 formed with the fifth conductive pattern CP5.

Meanwhile, selectively, the light emitting device may further include a second color filter which is disposed between the second light emitting part LE2 and the third light emitting part LE3. For instance, the second color filter may be disposed on the third ohmic layer 308. The second color filter may reflect the light generated from each of the first light emitting part LE1 and the second light emitting part LE2 and pass the light generated from the third light emitting part LE3, so that the light generated from the first light emitting part LE1 and the second light emitting part LE2 does not exert an influence on the third light emitting part LE3. The second color filter may include a DBR having a structure in which TiO2 and SiO2 are alternately stacked. For example, the alternation sequence or number of TiO2 and SiO2 in the second color filter may be different from the alternation sequence or number of TiO2 and SiO2 in the first color filter.

The third light emitting part LE3 may include a sixth hole HL6 which passes through the third light emitting part LE3 and the second adhesion part AD2 and exposes the third conductive pattern CP3, a seventh hole HL7 which exposes the third ohmic layer 308 of the third light emitting part LE3, an eighth hole which passes through the third light emitting part LE3 and the second adhesion part AD2 and exposes the fourth conductive pattern CP4, and a ninth hole which passes through the third light emitting part LE3 and the second adhesion part AD2 and exposes the fifth conductive pattern CP5. For instance, the third light emitting part LE3 may further include a tenth hole HL10 which exposes the third n-type semiconductor layer 302 as a portion of the third n-type semiconductor layer 302 is etched. The tenth hole HL10 may be selectively formed, and may be omitted as the case may be.

The sixth hole HL6 may expose the second portion CP3_2 of the third conductive pattern CP3, the eighth hole HL8 may expose the second portion CP4_2 of the fourth conductive pattern CP4, and the ninth hole HL9 may expose the second portion CP5_2 of the fifth conductive pattern CP5. As shown, the second portion CP3_2 of the third conductive pattern CP3, the second portion CP4_2 of the fourth conductive pattern CP4 and the second portion CP5_2 of the fifth conductive pattern CP5 may be positioned on the same plane as they extend on the top surface of the second light emitting part LE2. Thus, the sixth hole HL6, the eighth hole HL8 and the ninth hole HL9 may have substantially the same height.

According to an embodiment, each of the sixth hole HL6, the seventh hole HL7, the eighth hole HL8, the ninth hole HL9 and the tenth hole HL10 may have an inclined side surface of which width gradually decreases in the downward direction. A width WT of each of the sixth hole HL6, the seventh hole HL7, the eighth hole HL8, the ninth hole HL9 and the tenth hole HL10 may have substantially the same size. The width WT of each of the sixth hole HL6, the seventh hole HL7, the eighth hole HL8, the ninth hole HL9 and the tenth hole HL10 may be substantially the same as the width of each of the second hole HL2, the third hole HL3, the fourth hole HL4 and the fifth hole HL5. For example, the width WT of each of the sixth hole HL6, the seventh hole HL7, the eighth hole HL8, the ninth hole HL9 and the tenth hole HL10 may be approximately 1/10 of the size of the light emitting device.

The light emitting device may further include a sixth conductive pattern CP6 which at least partially fills the sixth hole HL6, is brought into electrical contact with the second portion of the third conductive pattern CP3 and extends onto the third light emitting part LE3, a seventh conductive pattern CP7 which at least partially fills the seventh hole HL7, is brought into electrical contact with the third ohmic layer 308 and extends onto the third light emitting part LE3, an eighth conductive pattern CP8 which at least partially fills the eighth hole HL8, is brought into electrical contact with the second portion of the fourth conductive pattern CP4 and extends onto the third light emitting part LE3, and a ninth conductive pattern CP9 which at least partially fills the ninth hole HL9 and the tenth hole HL10, is brought into electrical contact with the second portion of the fifth conductive pattern CP5 and extends onto the third light emitting part LE3. Each of the sixth conductive pattern CP6, the seventh conductive pattern CP7, the eighth conductive pattern CP8 and the ninth conductive pattern CP9 may include at least one selected from the group consisting of Au, Ag, Ni, Al, Rh, Pd, Ir, Ru, Mg, Zn, Pt, Hf, Cr, Ti and Cu. Further, each of the sixth conductive pattern CP6, the seventh conductive pattern CP7, the eighth conductive pattern CP8 and the ninth conductive pattern CP9 may include an alloy thereof.

According to an embodiment, the sixth conductive pattern CP6 may be electrically coupled with the third conductive pattern CP3, the third conductive pattern CP3 may be electrically coupled with the second conductive pattern CP2, and the second conductive pattern CP2 may be electrically coupled with the first ohmic layer 108. By this fact, the sixth conductive pattern CP6 may be electrically coupled with the first ohmic layer 108 of the first light emitting part LE1. The seventh conductive pattern CP7 may be electrically coupled with the third ohmic layer 308 of the third light emitting part LE3. The eighth conductive pattern CP8 may be electrically coupled with the fourth conductive pattern CP4, and the fourth conductive pattern CP4 may be electrically coupled with the second ohmic layer 208. By this fact, the eight conductive pattern CP8 may be electrically coupled with the second ohmic layer 208 of the second light emitting part LE2. The ninth conductive pattern CP9 may be electrically coupled with the third n-type semiconductor layer 302 and the fifth conductive pattern CP5, the fifth conductive pattern CP5 may be electrically coupled with the second n-type semiconductor layer 202 and the first conductive pattern CP1, and the first conductive pattern CP1 may be electrically coupled with the first n-type semiconductor layer 102. By this fact, the ninth conductive pattern CP9 may be electrically coupled in common with the first n-type semiconductor layer 102, the second n-type semiconductor layer 202 and the third n-type semiconductor layer 302.

According to the embodiment shown in FIG. 1b, the sixth conductive pattern CP6 may not completely fill the sixth hole HL6, and may be thinly and conformally formed along the inner sidewall of the sixth hole HL6. The sixth conductive pattern CP6 may include a first portion CP6_1 which is disposed in the sixth hole HL6 and a second portion CP6_2 which extends from the first portion CP6_1 to the top surface of the third light emitting part LE3. The seventh conductive pattern CP7 may not completely fill the seventh hole HL7, and may be thinly and conformally formed along the inner sidewall of the seventh hole HL7. The seventh conductive pattern CP7 may include a first portion CP7_1 which is disposed in the seventh hole HL7 and a second portion CP7_2 which extends from the first portion CP7_1 to the top surface of the third light emitting part LE3. The eighth conductive pattern CP8 may not completely fill the eighth hole HL8, and may be thinly and conformally formed along the inner sidewall of the eighth hole HL8. The eighth conductive pattern CP8 may include a first portion CP8_1 which is disposed in the eighth hole HL8 and a second portion CP8_2 which extends from the first portion CP8_1 to the top surface of the third light emitting part LE3. The ninth conductive pattern CP9 may not completely fill the ninth hole HL9 and the tenth hole HL10, and may be thinly and conformally formed along the inner sidewalls of the ninth hole HL9 and the tenth hole HL10. The ninth conductive pattern CP9 may include first portions CP9_1 which are respectively disposed in the ninth hole HL9 and the tenth hole HL10 and a second portion CP9_2 which couples the first portions CP9_1 between the first portions CP9_1 and extends to the top surface of the third light emitting part LE3. The second portion CP9_2 of the ninth conductive pattern CP9 may be disposed between the ninth hole HL9 and the tenth hole HL10. However, it is to be noted that the disclosure is not limited thereto.

According to another embodiment shown in FIG. 1c, the sixth conductive pattern CP6 may include a first portion CP6_1 which fills the sixth hole HL6 and a second portion CP6_2 which extends from the first portion CP6_1 and extends on the top surface of the third light emitting part LE3. The seventh conductive pattern CP7 may include a first portion CP7_1 which fills the seventh hole HL7 and a second portion CP7_2 which extends from the first portion CP7_1 and extends on the top surface of the third light emitting part LE3. The eighth conductive pattern CP8 may include a first portion CP8_1 which fills the eighth hole HL8 and a second portion CP8_2 which extends from the first portion CP8_1 and extends on the top surface of the third light emitting part LE3. The ninth conductive pattern CP9 may include first portions CP9_1 which respectively fill the ninth hole HL9 and the tenth hole HL10 and a second portion CP9_2 which couples the first portions CP9_1, extends from the first portions CP9-1 and extends on the top surface of the third light emitting part LE3.

The light emitting device may further include a second passivation layer PVT2 which surrounds the outer sidewall of the sixth conductive pattern CP6 between the sixth conductive pattern CP6 and the sixth hole HL6, surrounds the outer sidewall of the seventh conductive pattern CP7 between the seventh conductive pattern CP7 and the seventh hole HL7, surrounds the outer sidewall of the eighth conductive pattern CP8 between the eighth conductive pattern CP8 and the eighth hole HL8, surrounds the outer sidewall of the ninth conductive pattern CP9 between the ninth conductive pattern CP9 and the ninth hole HL9 and the tenth hole HL10, and extends to the top surface of the third light emitting part LE3 to insulate the sixth conductive pattern CP6, the seventh conductive pattern CP7, the eighth conductive pattern CP8 and the ninth conductive pattern CP9 from the third light emitting part LE3. The second passivation layer PVT2 may include the same material as the first passivation layer PVT1. For example, the second passivation layer PVT2 may include at least one selected from the group consisting of SiNx, TiNx, TiOx, TaOx, ZrOx, HfOx, AlxOy, and SiOx.

According to an embodiment, the third light emitting part LE3 may have an inclined side surface such that it has a wider width in the downward direction. That is to say, the third ohmic layer 308 of the third light emitting part LE3 may be larger than the third p-type semiconductor layer 306, the third p-type semiconductor layer 306 may be larger than the third active layer 304, and the third active layer 304 may be larger than the third n-type semiconductor layer 302. The second passivation layer PVT2 may extend to surround the outer sidewall of the third light emitting part LE3.

The light emitting device may further include a first pad PD1 which is brought into electrical contact with the sixth conductive pattern CP6 on the sixth conductive pattern CP6 electrically coupled with the first ohmic layer 108, a second pad PD2 which is brought into electrical contact with the eighth conductive pattern CP8 on the eighth conductive pattern CP8 electrically coupled with the second ohmic layer 208, a third pad PD3 which is brought into electrical contact with the seventh conductive pattern CP7 on the seventh conductive pattern CP7 electrically coupled with the third ohmic layer 308, and a common pad CPD which is brought into electrical contact with the ninth conductive pattern CP9 on the ninth conductive pattern CP9 electrically coupled with the first n-type semiconductor layer 102, the second n-type semiconductor layer 202 and the third n-type semiconductor layer 302. Each of the first pad PD1, the second pad PD2, the third pad PD3 and the common pad CPD may include at least one selected from the group consisting of Au, Ag, Ni, Al, Rh, Pd, Ir, Ru, Mg, Zn, Pt, Hf, Cr, Ti and Cu. Further, each of the first pad PD1, the second pad PD2, the third pad PD3 and the common pad CPD may include an alloy thereof.

According to an embodiment, in the case where the light emitting device has a quadrangular structure when viewed from the top, the first pad PD1, the second pad PD2, the third pad PD3 and the common pad CPD may be respectively disposed at corner portions of the light emitting device. For instance, the first pad PD1 may be disposed at a first corner CN1, the second pad PD2 may be disposed at a third corner CN3, the third pad PD3 may be disposed at a second corner CN2, and the common pad CPD may be disposed at a fourth corner CN4.

The light emitting device may further include a third passivation layer PVT3 which covers the other portions except the first pad PD1, the second pad PD2, the third pad PD3 and the common pad CPD on the third light emitting part LE3. The third passivation layer PVT3 may include the same material as the first passivation layer PVT1 or the second passivation layer PVT2. For example, the third passivation layer PVT3 may include at least one selected from the group consisting of SiNx, TiNx, TiOx, TaOx, ZrOx, HfOx, AlxOy and SiOx. According to an embodiment, the second passivation layer PV2 may be disposed between the outer sidewall of the third light emitting part LE3 and the third passivation layer PVT3. In another instance, the second passivation layer PV2 may be omitted between the outer sidewall of the third light emitting part LE3 and the third passivation layer PVT3.

In the example shown in FIG. 1b, the third passivation layer PVT3 may be conformally formed on the second passivation layer PVT2 in such a way as not to completely fill the sixth hole HL6, the seventh hole HL7, the eighth hole HL8, the ninth hole HL9 and the tenth hole HL10 formed with the sixth conductive pattern CP6, the seventh conductive pattern CP7, the eighth conductive pattern CP8 and the ninth conductive pattern CP9. Unlike this, the third passivation layer PVT3 may be formed in such a way as to fill the sixth hole HL6, the seventh hole HL7, the eighth hole HL8, the ninth hole HL9 and the tenth hole HL10 formed with the sixth conductive pattern CP6, the seventh conductive pattern CP7, the eighth conductive pattern CP8 and the ninth conductive pattern CP9.

In another example shown in FIG. 1c, the third passivation layer PVT3 may be formed on the top surfaces of the sixth conductive pattern CP6, the seventh conductive pattern CP7, the eighth conductive pattern CP8 and the ninth conductive pattern CP9 and on the second passivation layer PVT2.

In the light emitting device described above, in the second light emitting part LE2 and the first adhesion part AD1, the second hole HL2 which exposes the second conductive pattern CP2 electrically coupled with the first ohmic layer 108, the third hole HL3 which exposes the second ohmic layer 208, the fourth hole HL4 which exposes the first conductive pattern CP1 electrically coupled with the first n-type semiconductor layer 102 and the fifth hole HL5 which exposes the second n-type semiconductor layer 202 may be formed, and the third conductive pattern CP3, the fourth conductive pattern CP4 and the fifth conductive pattern CP5 which at least partially fill the second hole HL2, the third hole HL3, the fourth hole HL4 and the fifth hole HL5 may be disposed. Further, in the third light emitting part LE3 and the second adhesion part AD2, the sixth hole HL6 which exposes the third conductive pattern CP3, the seventh hole HL7 which exposes the third ohmic layer 308, the eighth hole HL8 which exposes the fourth conductive pattern CP4, the ninth hole HL9 which exposes the fifth conductive pattern CP5 and the tenth hole HL10 which exposes the third n-type semiconductor layer 302 may be formed, and the sixth conductive pattern CP6, the seventh conductive pattern CP7, the eighth conductive pattern CP8 and the ninth conductive pattern CP9 which at least partially fill the sixth hole HL6, the seventh hole HL7, the eighth hole HL8, the ninth hole HL9 and the tenth hole HL10 may be disposed. In this way, conductive patterns electrically coupled with the first light emitting part LE1 may be disposed in the second light emitting part LE2 and the first adhesion part AD1, and conductive patterns electrically coupled with the conductive patterns coupled with the first light emitting part LE1 may be separately disposed in the third light emitting part LE3 and the second adhesion part AD2. Therefore, the first pad PD1 may be electrically stably coupled with the first ohmic layer 108 through the third conductive pattern CP3 and the second conductive pattern CP2 along the sixth conductive pattern CP6. The second pad PD2 may be electrically stably coupled with the second ohmic layer 208 through the fourth conductive pattern CP4 along the eighth conductive pattern CP8. The third pad PD3 may be electrically stably coupled with the third ohmic layer 308 through the seventh conductive pattern CP7. Further, the common pad CPD may be electrically stably coupled with the third n-type semiconductor layer 302 through the ninth conductive pattern CP9, with the second n-type semiconductor layer 202 through the fifth conductive pattern CP5 along the ninth conductive pattern CP9, and with the first n-type semiconductor layer 102 through the first conductive pattern CP1 along the fifth conductive pattern CP5.

Meanwhile, in a light emitting device, processes are performed on a substrate which is made of a material such as sapphire, and, while the processes are performed, a tensile stress may be induced so that a warpage phenomenon in which the center portion of the substrate warps downward occurs. In this regard, in the embodiment of the disclosure, the first adhesion part AD1 and the second adhesion part AD2 may mitigate the tensile stress applied to the substrate.

Moreover, as will be described in detail in a subsequent manufacturing method, the first light emitting part LE1 is isolated while the first hole HL1 is formed, the second light emitting part LE2 is isolated while the second hole HL2, the third hole HL3, the fourth hole HL4 and the fifth hole HL5 are formed, and the third light emitting part LE3 is isolated while the sixth hole HL6, the seventh hole HL7, the eighth hole HL8, the ninth hole HL9 and the tenth hole HL10 are formed, whereby it is possible to further mitigate the tensile stress applied to the substrate.

Hereafter, a method for manufacturing the light emitting device of FIGS. 1a and 1b will be described.

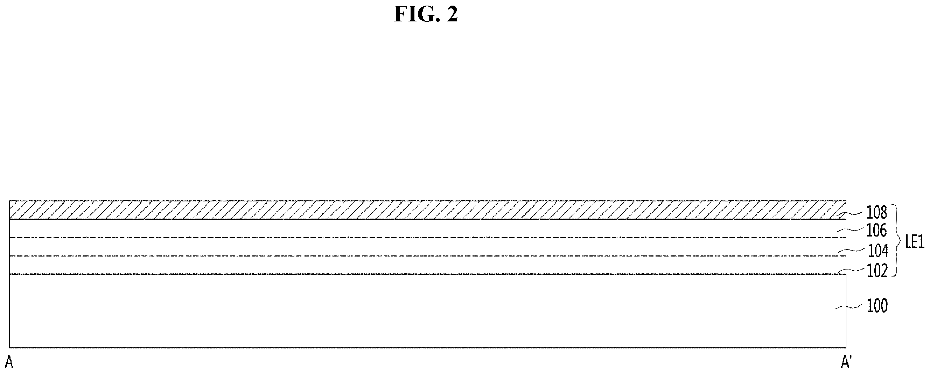

FIGS. 2 to 16 are representations of examples of cross-sectional views to assist in the explanation of a method for manufacturing a light emitting device in accordance with an embodiment of the disclosure.

Referring to FIG. 2, a first n-type semiconductor layer 102, a first active layer 104, a first p-type semiconductor layer 106 and a first ohmic layer 108 may be sequentially formed on a first substrate 100, and thereby, a first light emitting part LE1 may be formed.

The first substrate 100 as a substrate capable of growing a gallium nitride-based semiconductor layer may include a sapphire (Al2O3), a silicon carbide (SiC), a gallium nitride (GaN), an indium gallium nitride (InGaN), an aluminum gallium nitride (AlGaN), an aluminum nitride (AlN), a gallium oxide (Ga2O3), a gallium arsenic (GaAs) or silicon (Si). Also, the first substrate 100 may be a flexible substrate or a substrate which is formed with a circuit.

The first n-type semiconductor layer 102, the first active layer 104 and the first p-type semiconductor layer 106 may be sequentially formed on the first substrate 100 by using a growing method such as MOCVD (metal organic chemical vapor deposition), MBE (molecular beam epitaxy), HVPE (hydride vapor phase epitaxy) and MOC (metal-organic chloride).

The first ohmic layer 108 may be formed on the first p-type semiconductor layer 106 through a chemical vapor deposition (CVD) process or a physical vapor deposition (PVD).

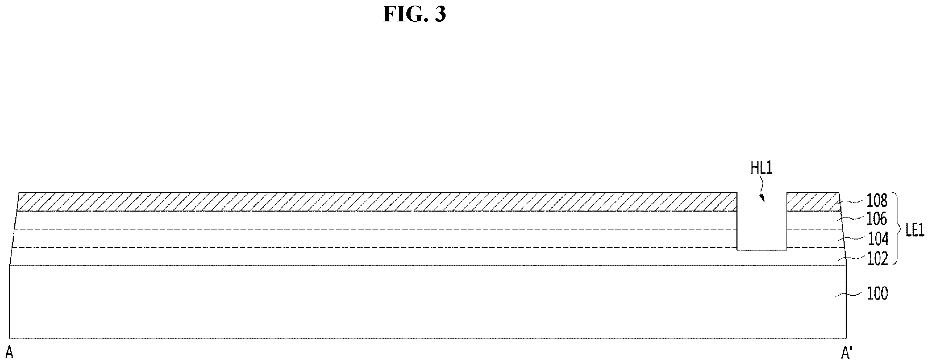

Referring to FIG. 3, by etching the first ohmic layer 108, the first p-type semiconductor layer 106 and the first active layer 104, a first hole HL1 may be formed in the first light emitting part LE1. The etching process may etch a top portion of the first n-type semiconductor layer 102.

After forming the first hole HL1, by etching the first ohmic layer 108, the first p-type semiconductor layer 106, the first active layer 104 and the first n-type semiconductor layer 102, the first light emitting part LE1 may be isolated.

In this way, by isolating the first light emitting part LE1, a tensile stress to be applied to the first substrate 100 may be reduced.

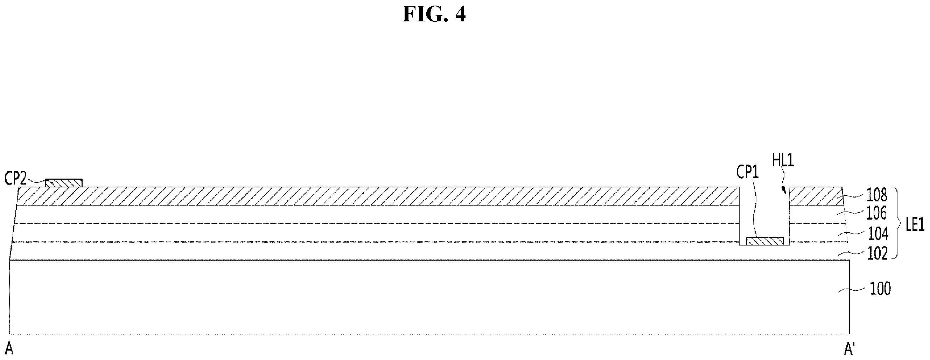

Referring to FIG. 4, a first conductive pattern CP1 and a second conductive pattern CP2 may be respectively formed in the first light emitting part LE1. The first conductive pattern CP1 may be formed in the first hole HL1 by being separated from the inner sidewall of the first hole HL1. The second conductive pattern CP2 may be formed on the first ohmic layer 108.

For instance, after forming a conductive layer on the top surface of the first light emitting part LE1 formed with the first hole HL1, the first conductive pattern CP1 and the second conductive pattern CP2 may be respectively formed through a patterning process generally known in the art.

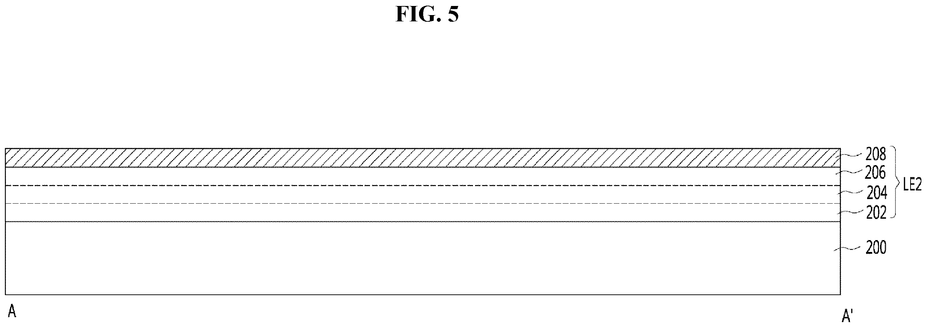

Referring to FIG. 5, a second n-type semiconductor layer 202, a second active layer 204, a second p-type semiconductor layer 206 and a second ohmic layer 208 may be sequentially formed on a second substrate 200, and thereby, a second light emitting part LE2 may be formed.

The second substrate 200 as a substrate capable of growing a gallium nitride-based semiconductor layer may include a sapphire (Al2O3), a silicon carbide (SiC), a gallium nitride (GaN), an indium gallium nitride (InGaN), an aluminum gallium nitride (AlGaN), an aluminum nitride (AlN), a gallium oxide (Ga2O3), a gallium arsenic (GaAs) or silicon (Si). Also, the second substrate 200 may be a flexible substrate or a substrate which is formed with a circuit.

The second n-type semiconductor layer 202, the second active layer 204 and the second p-type semiconductor layer 206 may be sequentially formed on the second substrate 200 by using a growing method such as MOCVD, MBE, HVPE and MOC.

The second ohmic layer 208 may be formed on the second p-type semiconductor layer 206 through a CVD or PVD process.

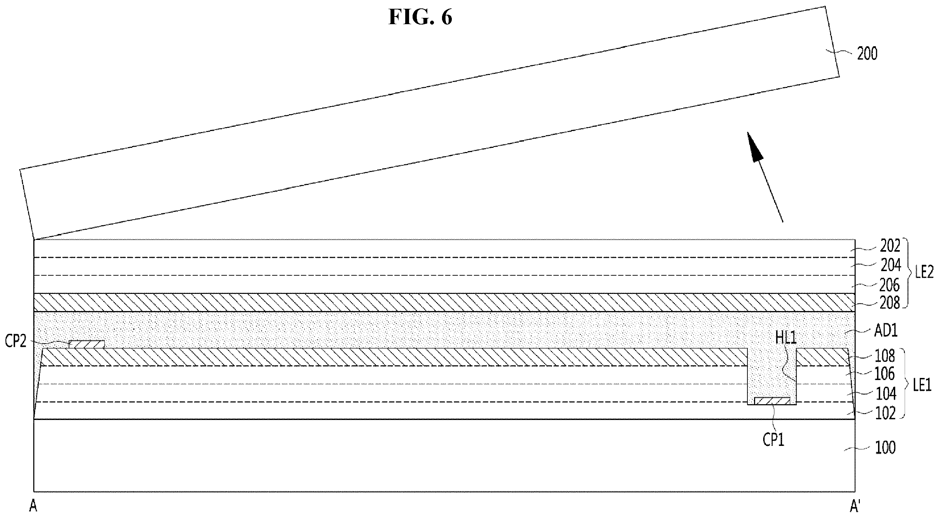

Referring to FIG. 6, by turning over the second substrate 200, the first ohmic layer 108 of the first light emitting part LE1 and the second ohmic layer 208 of the second light emitting part LE2 may be disposed to face each other, and the first light emitting part LE1 and the second light emitting part LE2 may be bonded with each other through a first adhesion part AD1.

For instance, after the first adhesion part AD1 is formed on the first light emitting part LE1 to fill the first hole HL1 formed with the first conductive pattern CP1 and the second ohmic layer 208 is disposed to face the first ohmic layer 108, by curing the first adhesion part AD1 through a thermal process, the first light emitting part LE1 and the second light emitting part LE2 may be bonded with each other.

In this case, the first light emitting part LE1 may be surrounded by the first adhesion part AD1, and the first adhesion part AD1 may be a protective layer that protects the side surface of the first light emitting part LE1.

After the first light emitting part LE1 and the second light emitting part LE2 are bonded with each other by the first adhesion part AD1, the second substrate 200 may be removed through a laser lift-off (LLO) process.

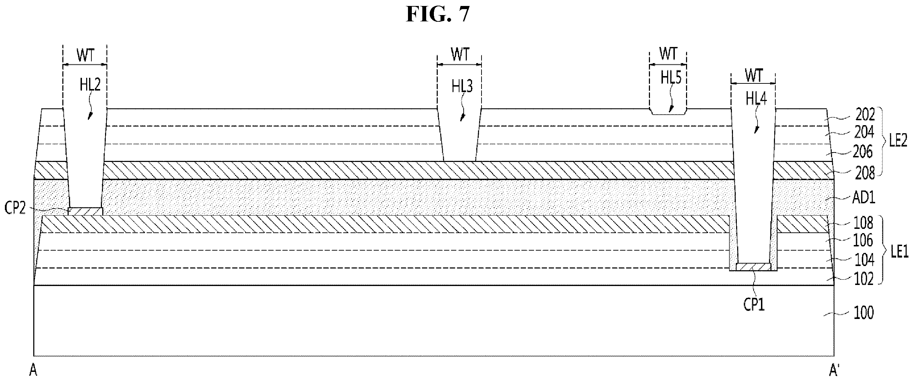

Referring to FIG. 7, by etching the second light emitting part LE2 and the first adhesion part AD1, a second hole HL2 which exposes the second conductive pattern CP2, a third hole HL3 which exposes the second ohmic layer 208, a fourth hole HL4 which exposes the first conductive pattern CP1 and a fifth hole HL5 which exposes a portion of the second n-type semiconductor layer 202 may be formed. Selectively, the fifth hole HL5 may not be formed.

Each of the second hole HL2, the third hole HL3, the fourth hole HL4 and the fifth hole HL5 may have the same width WT. Each of the second hole HL2, the third hole HL3, the fourth hole HL4 and the fifth hole HL5 may have an inclined side surface of which width gradually decreases in a downward direction.

While forming the second hole HL2, the third hole HL3, the fourth hole HL4 and the fifth hole HL5, by etching the second n-type semiconductor layer 202, the second active layer 204, the second p-type semiconductor layer 206 and the first ohmic layer 108, the second light emitting part LE2 may be isolated.

In this way, by isolating the second light emitting part LE2, a tensile stress to be applied to the substrate 100 may be reduced. In addition, the second light emitting part LE2 has a tapered side surface. In other words, the second light emitting part LE2 has a shape in which an area of the second light emitting part LE2 gradually decreases toward an upper direction from the substrate 100.

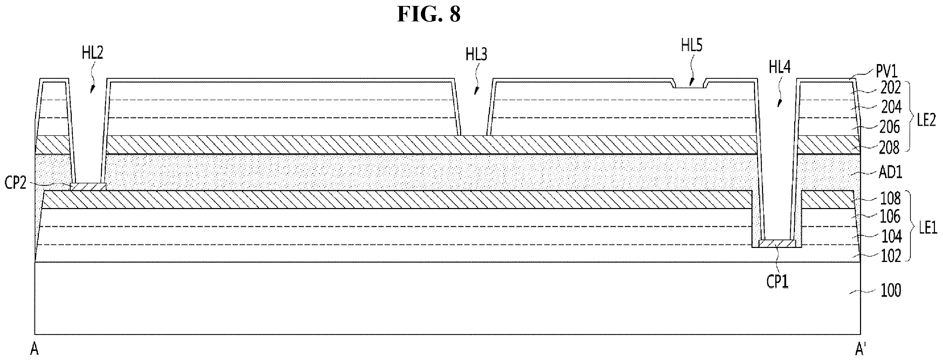

Referring to FIG. 8, a first passivation layer PV1 may be formed on the inner sidewalls of the second hole HL2, the third hole HL3, the fourth hole HL4 and the fifth hole HL5 and on the top surface of the second n-type semiconductor layer 202.

For instance, the first passivation layer PV1 may be conformally formed on the second light emitting part LE2 and the first adhesion part AD1 formed with the second hole HL2, the third hole HL3, the fourth hole HL4 and the fifth hole HL5, in such a way as not to completely fill the second hole HL2, the third hole HL3, the fourth hole HL4 and the fifth hole HL5. As each of the second hole HL2, the third hole HL3, the fourth hole HL4 and the fifth hole HL5 has an inclined side surface, it may be easy to conformally form the first passivation layer PV1. Then, the first passivation layer PV1 which is formed on the bottoms of the second hole HL2, the third hole HL3, the fourth hole HL4 and the fifth hole HL5 may be removed.

The first passivation layer PV1 may remain on the outer sidewall of the second light emitting part LE2. Unlike this, the first passivation layer PV1 may be removed from the outer sidewall of the second light emitting part LE2.

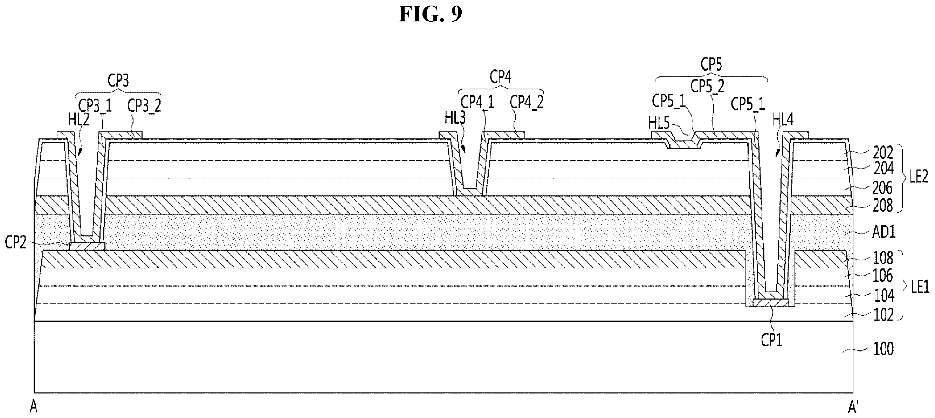

Referring to FIG. 9, a third conductive pattern CP3, a fourth conductive pattern CP4 and a fifth conductive pattern CP5 which at least partially fill the second hole HL2, the third hole HL3, the fourth hole HL4 and the fifth hole HL5 formed with the first passivation layer PV1 may be respectively formed.

For instance, by using a deposition process, a first conductive layer (not shown) may be conformally formed on the first passivation layer PV1 in such a way as not to completely fill the second hole HL2, the third hole HL3, the fourth hole HL4 and the fifth hole HL5 formed with the first passivation layer PV1. As described above, since each of the second hole HL2, the third hole HL3, the fourth hole HL4 and the fifth hole HL5 has an inclined side surface, it may be easy to conformally form the first conductive layer. In succession, the third conductive pattern CP3 which is electrically coupled with the first conductive pattern CP1 and at least partially fills the second hole HL2, the fourth conductive pattern CP4 which is electrically coupled with the second ohmic layer 208 and at least partially fills the third hole HL3, and the fifth conductive pattern CP5 which is electrically coupled with the first conductive pattern CP1, at least partially fills the fourth hole HL4, is electrically coupled with the second n-type semiconductor layer 202 and at least partially fills the fifth hole HL5 may be respectively formed.

The third conductive pattern CP3 may include a first portion CP3_1 which is formed in the second hole HL2 and a second portion CP3_2 which extends from the first portion CP3_1 onto the first passivation layer PV1 formed on the second n-type semiconductor layer 202. The fourth conductive pattern CP4 may include a first portion CP4_1 which is formed in the third hole HL3 and a second portion CP4_2 which extends from the first portion CP4_1 onto the first passivation layer PV1 formed on the second n-type semiconductor layer 202. The fifth conductive pattern CP5 may include first portions CP5_1 which are respectively formed in the fourth hole HL4 and the fifth hole HL5 and a second portion CP5_2 which couples the first portions CP5_1 and extends onto the first passivation layer PV1 formed on the second n-type semiconductor layer 202.

While it is illustrated and described in the present embodiment that the third conductive pattern CP3, the fourth conductive pattern CP4 and the fifth conductive pattern CP5 are thinly and conformally formed in such a way as not to completely fill the second hole HL2, the third hole HL3, the fourth hole HL4 and the fifth hole HL5, it is to be noted that the third conductive pattern CP3, the fourth conductive pattern CP4 and the fifth conductive pattern CP5 may be formed in such a way as to fill the second hole HL2, the third hole HL3, the fourth hole HL4 and the fifth hole HL5.

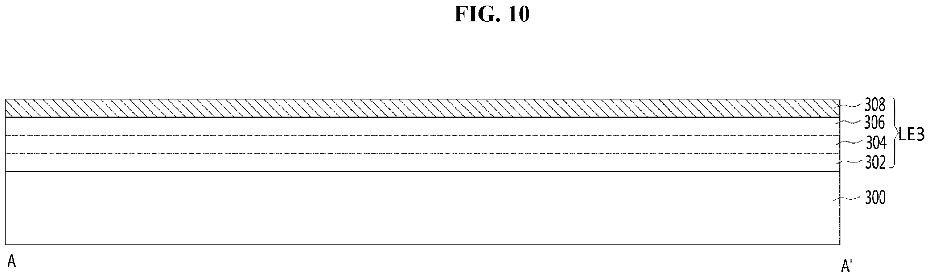

Referring to FIG. 10, a third n-type semiconductor layer 302, a third active layer 304, a third p-type semiconductor layer 306 and a third ohmic layer 308 may be sequentially formed on a third substrate 300, and thereby, a third light emitting part LE3 may be formed.

The third substrate 300 as a substrate capable of growing a gallium nitride-based semiconductor layer may include a sapphire (Al2O3), a silicon carbide (SiC), a gallium nitride (GaN), an indium gallium nitride (InGaN), an aluminum gallium nitride (AlGaN), an aluminum nitride (AlN), a gallium oxide (Ga2O3), a gallium arsenic (GaAs) or silicon (Si). Also, the third substrate 300 may be a flexible substrate or a substrate which is formed with a circuit.

The third n-type semiconductor layer 302, the third active layer 304 and the third p-type semiconductor layer 306 may be sequentially formed on the third substrate 300 by using a growing method such as MOCVD, MBE, HVPE and MOC.

The third ohmic layer 308 may be formed on the third p-type semiconductor layer 306 through CVD or PVD.

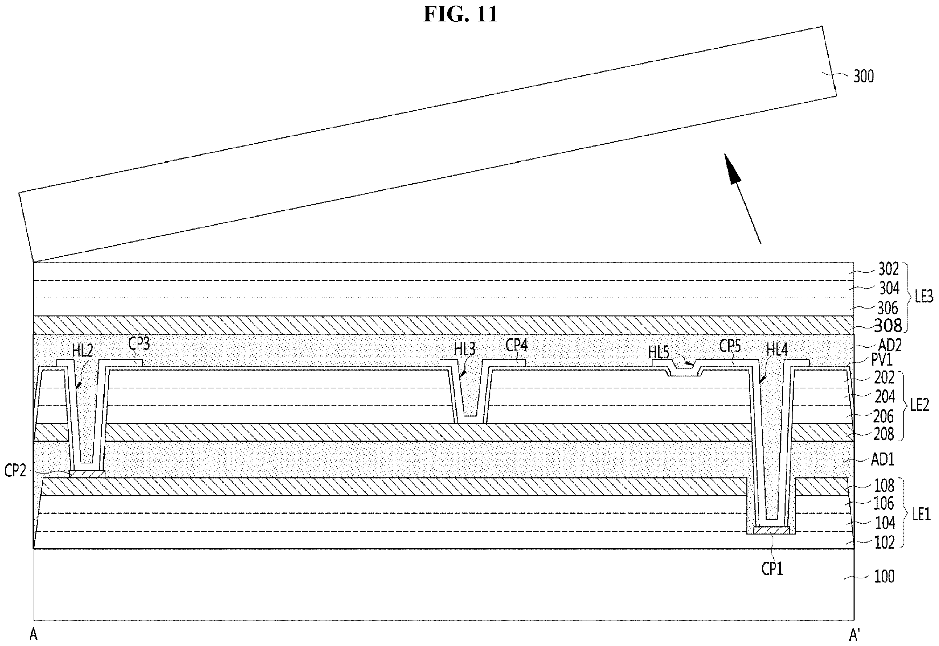

Referring to FIG. 11, by turning over the third substrate 300, the second n-type semiconductor layer 202 of the second light emitting part LE2 and the third ohmic layer 308 of the third light emitting part LE3 may be disposed to face each other, and the second light emitting part LE2 and the third light emitting part LE3 may be bonded to each other through a second adhesion part AD2.

For instance, after the second adhesion part AD2 is formed on the second light emitting part LE2 to fill the second hole HL2, the third hole HL3, the fourth hole HL4 and the fifth hole HL5 formed with the third conductive pattern CP3, the fourth conductive pattern CP4 and the fifth conductive pattern CP5 and the third ohmic layer 308 is disposed to face the second n-type semiconductor layer 202, by curing the second adhesion part AD2 through a thermal process, the second light emitting part LE2 and the third light emitting part LE3 may be bonded with each other.

In this case, the side of the second light emitting part LE2 may be surrounded by the second adhesion part AD2, and the second adhesion part AD2 may be a protective layer protecting the side of the second light emitting part LE2.

After the second light emitting part LE2 and the third light emitting part LE3 are bonded with each other by the second adhesion part AD2, the third substrate 300 may be removed through an LLO process.

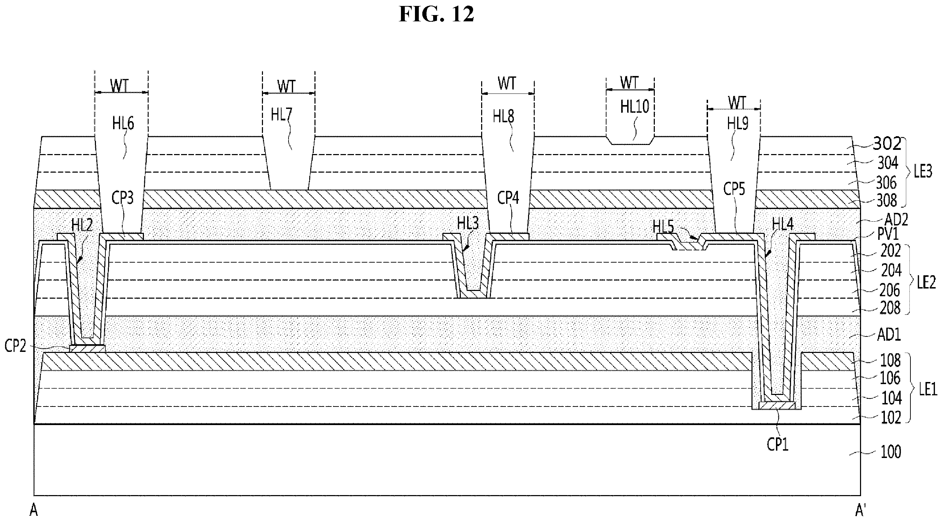

Referring to FIG. 12, by etching the third light emitting part LE3 and the second adhesion part AD2, a sixth hole HL6 which exposes the second portion of the third conductive pattern CP3, a seventh hole HL7 which exposes the third ohmic layer 308, an eighth hole HL8 which exposes the second portion of the fourth conductive pattern CP4, a ninth hole HL9 which exposes the second portion of the fifth conductive pattern CP5 and a tenth hole HL10 which exposes a portion of the third n-type semiconductor layer 302 may be formed. Selectively, the tenth hole HL10 may not be formed.

Each of the sixth hole HL6, the seventh hole HL7, the eighth hole HL8, the ninth hole HL9 and the tenth hole HL10 may have the same width WT. Each of the sixth hole HL6, the seventh hole HL7, the eighth hole HL8, the ninth hole HL9 and the tenth hole HL10 may have the same width WT as each of the second hole HL2, the third hole HL3, the fourth hole HL4 and the fifth hole HL5. Each of the sixth hole HL6, the seventh hole HL7, the eighth hole HL8, the ninth hole HL9 and the tenth hole HL10 may have an inclined side surface of which width gradually decreases in the downward direction.

While forming the sixth hole HL6, the seventh hole HL7, the eighth hole HL8, the ninth hole HL9 and the tenth hole HL10, by etching the third n-type semiconductor layer 302, the third active layer 304, the third p-type semiconductor layer 306 and the third ohmic layer 308, the third light emitting part LE3 may be isolated.

In this way, by isolating the third light emitting part LE3, a tensile stress to be applied to the substrate 100 may be reduced.

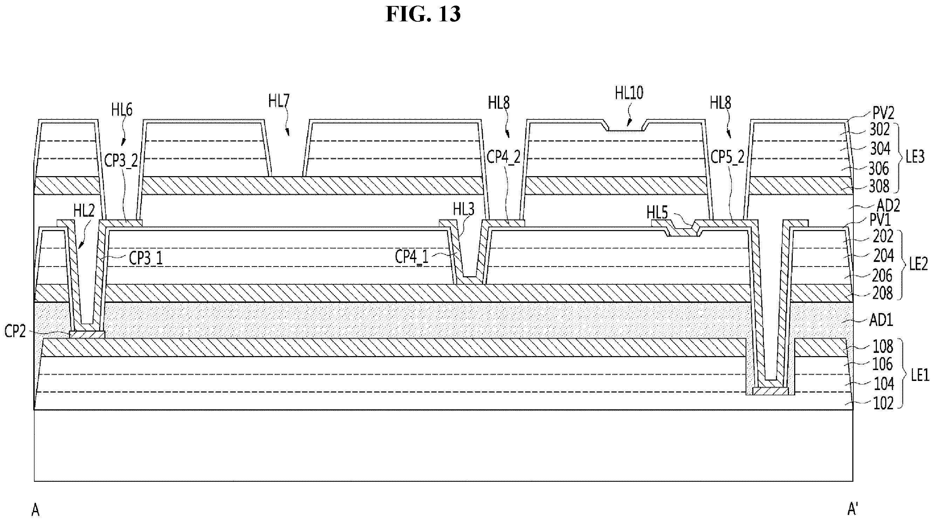

Referring to FIG. 13, a second passivation layer PV2 may be formed on the inner sidewalls of the sixth hole HL6, the seventh hole HL7, the eighth hole HL8, the ninth hole HL9 and the tenth hole HL10 and on the top surface of the third n-type semiconductor layer 302.

For instance, the second passivation layer PV2 may be conformally formed on the third light emitting part LE3 and the second adhesion part AD2 formed with the sixth hole HL6, the seventh hole HL7, the eighth hole HL8, the ninth hole HL9 and the tenth hole HL10, in such a way as not to completely fill the sixth hole HL6, the seventh hole HL7, the eighth hole HL8, the ninth hole HL9 and the tenth hole HL10. As each of the sixth hole HL6, the seventh hole HL7, the eighth hole HL8, the ninth hole HL9 and the tenth hole HL10 has an inclined side surface, it may be easy to conformally form the second passivation layer PV2. Then, the second passivation layer PV2 formed on the bottoms of the sixth hole HL6, the seventh hole HL7, the eighth hole HL8, the ninth hole HL9 and the tenth hole HL10 may be removed.

The second passivation layer PV2 may remain on the outer sidewall of the third light emitting part LE3. Unlike this, the second passivation layer PV2 may be removed from the outer sidewall of the third light emitting part LE3.

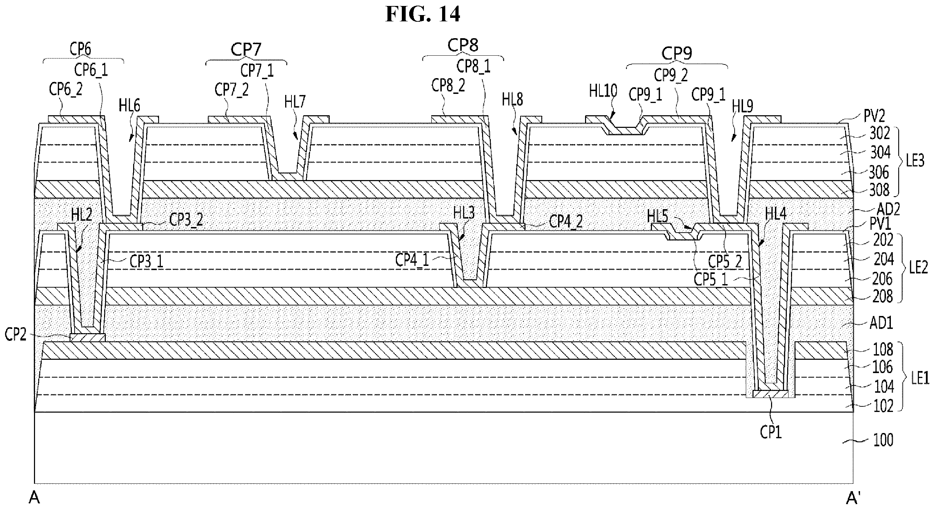

Referring to FIG. 14, a sixth conductive pattern CP6, a seventh conductive pattern CP7, an eighth conductive pattern CP8 and a ninth conductive pattern CP9 which at least partially fill the sixth hole HL6, the seventh hole HL7, the eighth hole HL8, the ninth hole HL9 and the tenth hole HL10 formed with the second passivation layer PV2 may be respectively formed.

For instance, a second conductive layer (not shown) may be conformally formed on the second passivation layer PV2 in such a way as not to completely fill the sixth hole HL6, the seventh hole HL7, the eighth hole HL8, the ninth hole HL9 and the tenth hole HL10 formed with the second passivation layer PV2. As described above, as each of the sixth hole HL6, the seventh hole HL7, the eighth hole HL8, the ninth hole HL9 and the tenth hole HL10 has an inclined side surface, it may be easy to conformally form the second conductive layer. In succession, through generally performing an etching process for the second conductive layer, the sixth conductive pattern CP6 which is electrically coupled with the second portion CP2_2 of the third conductive pattern CP3 and at least partially fills the sixth hole HL6, the seventh conductive pattern CP7 which is electrically coupled with the third ohmic layer 308 and at least partially fills the seventh hole HL7, the eighth conductive pattern CP8 which is electrically coupled with the second portion CP4_2 of the fourth conductive pattern CP4 and at least partially fills the eighth hole HL8 and the ninth conductive pattern CP9 which is electrically coupled with the second portion CP5_2 of the fifth portion and at least partially fills the ninth hole HL9 and the tenth hole HL10 may be respectively formed.

The sixth conductive pattern CP6 may include a first portion CP6_1 which is formed in the sixth hole HL6 and a second portion CP6_2 which extends from the first portion CP6_1 onto the second passivation layer PV2 formed on the third n-type semiconductor layer 302. The seventh conductive pattern CP7 may include a first portion CP7_1 which is formed in the seventh hole HL7 and a second portion CP7_2 which extends from the first portion CP7_1 onto the second passivation layer PV2 formed on the third n-type semiconductor layer 302. The eighth conductive pattern CP8 may include a first portion CP8_1 which is formed in the eighth hole HL8 and a second portion CP8_2 which extends from the first portion CP8_1 onto the second passivation layer PV2 formed on the third n-type semiconductor layer 302. The ninth conductive pattern CP9 may include first portions CP9_1 which are respectively formed in the ninth hole HL9 and the tenth hole HL10 and a second portion CP9_2 which couples the first portions CP9_1 and extends onto the second passivation layer PV2 formed on the third n-type semiconductor layer 302.

While it is illustrated and described in the present embodiment that the sixth conductive pattern CP6, the seventh conductive pattern CP7, the eighth conductive pattern CP8 and the ninth conductive pattern CP9 are thinly and conformally formed in such a way as not to completely fill the sixth hole HL6, the seventh hole HL7, the eighth hole HL8, the ninth hole HL9 and the tenth hole HL10, it is to be noted that the sixth conductive pattern CP6, the seventh conductive pattern CP7, the eighth conductive pattern CP8 and the ninth conductive pattern CP9 may be formed in such a way as to fill the sixth hole HL6, the seventh hole HL7, the eighth hole HL8, the ninth hole HL9 and the tenth hole HL10.

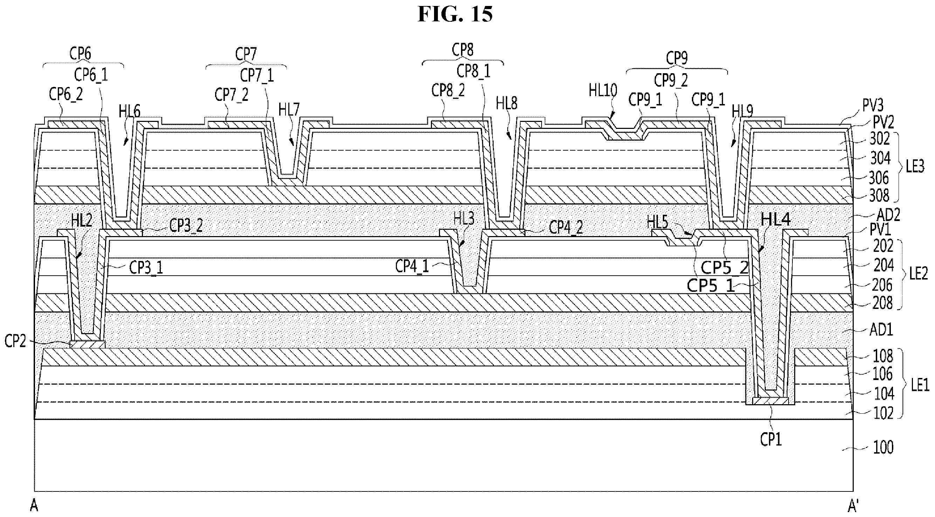

Referring to FIG. 15, a third passivation layer PV3 may be conformally formed on the sixth conductive pattern CP6, the seventh conductive pattern CP7, the eighth conductive pattern CP8 and the ninth conductive pattern CP9 and on the second passivation layer PV2. The third passivation layer PV3 may be thinly and conformally formed in such a way as not to completely fill the sixth hole HL6, the seventh hole HL7, the eighth hole HL8, the ninth hole HL9 and the tenth hole HL10 formed with the sixth conductive pattern CP6, the seventh conductive pattern CP7, the eighth conductive pattern CP8 and the ninth conductive pattern CP9.

The third passivation layer PV3 may be formed on the second passivation layer PV2 which is formed on the outer sidewall of the third light emitting part LE3.

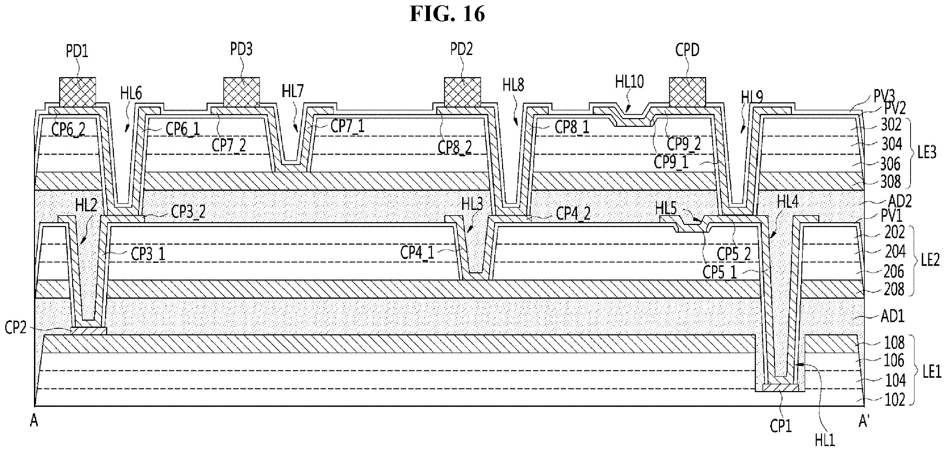

Referring to FIG. 16, a first pad PD1 which is electrically coupled with the sixth conductive pattern CP6, a second pad PD2 which is electrically coupled with the eighth conductive pattern CP8, a third pad PD3 which is electrically coupled with the seventh conductive pattern CP7 and a common pad CPD which is electrically coupled with the ninth conductive pattern CP9 may be respectively formed.

For instance, by etching the third passivation layer PV3, a first opening OP1 which exposes the second portion CP6_2 of the sixth conductive pattern CP6, a second opening OP2 which exposes the second portion CP8_2 of the eighth conductive pattern CP8, a third opening OP3 which exposes the second portion CP7_2 of the seventh conductive pattern CP7 and a third opening OP3 which exposes the second portion CP9_2 of the ninth conductive pattern CP9 may be formed.

A third conductive layer (not shown) may be formed on the third passivation layer PV3 in such a way as to fill the first opening OP1, the second opening OP2, the third opening OP3 and the fourth opening OP4. Through generally performing an etching process for the third conductive layer, the first pad PD1 which fills the first opening OP1 and is electrically coupled with the first ohmic layer 108 by being brought into electrical contact with the sixth conductive pattern CP6, the second pad PD2 which fills the second opening OP2 and is electrically coupled with the second ohmic layer 208 by being brought into electrical contact with the eighth conductive pattern CP8, the third pad PD3 which fills the third opening OP3 and is electrically coupled with the third ohmic layer 308 by being brought into electrical contact with the seventh conductive pattern CP7 and the common pad CPD which fills the fourth opening OP4 and is electrically coupled in common with the third n-type semiconductor layer 302, the second n-type semiconductor layer 202 and the first n-type semiconductor layer 102 by being brought into electrical contact with the ninth conductive pattern CP9 may be formed.

According to the present embodiment, in the second light emitting part LE2 and the first adhesion part AD1, the second hole HL2 which exposes the second conductive pattern CP2 electrically coupled with the first ohmic layer 108, the third hole HL3 which exposes the second ohmic layer 208, the fourth hole HL4 which exposes the first conductive pattern CP1 electrically coupled with the first n-type semiconductor layer 102 and the fifth hole HL5 which exposes the second n-type semiconductor layer 202 may be formed. In another process, in the third light emitting part LE3 and the second adhesion part AD2, the sixth hole HL6 which exposes the third conductive pattern CP3, the seventh hole HL7 which exposes the third ohmic layer 308, the eighth hole HL8 which exposes the fourth conductive pattern CP4, the ninth hole HL9 which exposes the fifth conductive pattern CP5 and the tenth hole HL10 which exposes the third n-type semiconductor layer 302 may be formed. In this regard, in the case of forming, at a time, holes which pass through the first light emitting part LE1, the second light emitting part LE2 and the third light emitting part LE3, difficulties exist when performing an etching process, due to a problem caused in terms of aspect ratio. In the present embodiment, since one etching process is performed in the second light emitting part LE2 and the first adhesion part AD1 and another etching process is performed in the third light emitting part LE3 and the second adhesion part AD2, it is possible to overcome the difficulties.

Moreover, the third conductive pattern CP3, the fourth conductive pattern CP4 and the fifth conductive pattern CP5 which are electrically coupled with the first light emitting part LE1 may be disposed in the second light emitting part LE2 and the first adhesion part AD 1, and the sixth conductive pattern CP6, the seventh conductive pattern CP7, the eighth conductive pattern CP8 and the ninth conductive pattern CP9 which are electrically coupled with the third conductive pattern CP3, the fourth conductive pattern CP4 and the fifth conductive pattern CP5 coupled with the first light emitting part LE1 may be separately disposed in the third light emitting part LE3 and the second adhesion part AD2. Therefore, the first pad PD1 may be electrically stably coupled with the first ohmic layer 108 through the third conductive pattern CP3 and the second conductive pattern CP2 along the sixth conductive pattern CP6. The second pad PD2 may be electrically stably coupled with the second ohmic layer 208 through the fourth conductive pattern CP4 along the eighth conductive pattern CP8. The third pad PD3 may be electrically stably coupled with the third ohmic layer 308 through the seventh conductive pattern CP7. Further, the common pad CPD may be electrically stably coupled with the third n-type semiconductor layer 302 through the ninth conductive pattern CP9, with the second n-type semiconductor layer 202 through the fifth conductive pattern CP5 along the ninth conductive pattern CP9, and with the first n-type semiconductor layer 102 through the first conductive pattern CP1 along the fifth conductive pattern CP5.

Hereafter, a method for mounting the light emitting device described above with reference to FIGS. 2 to 16 onto a mounting board will be described.

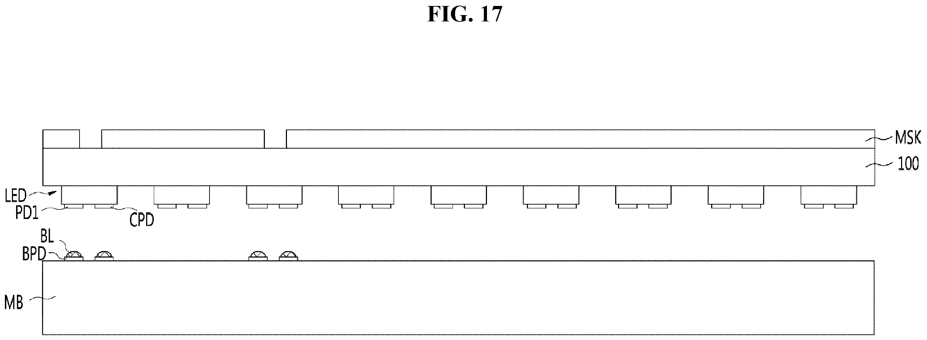

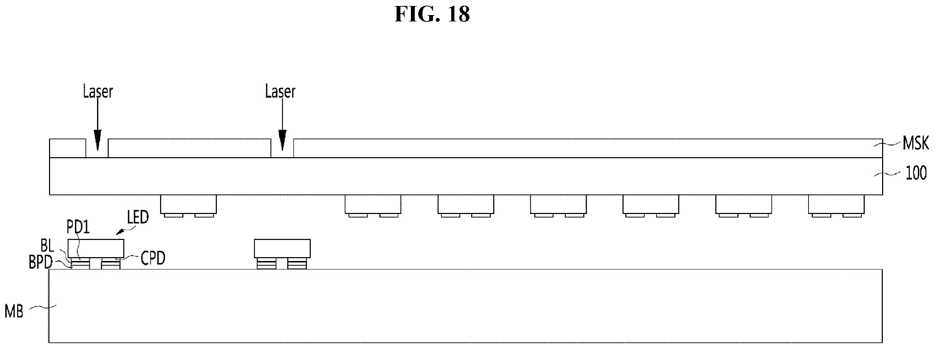

FIGS. 17 and 18 are representations of examples of cross-sectional views to assist in the explanation of a method for mounting light emitting devices to a mounting board in accordance with an embodiment of the disclosure.

Referring to FIG. 17, a plurality of light emitting devices LED which are formed through FIGS. 2 to 16 may be mounted to a target mounting board MB.

Bonding pads BPD which are to be electrically bonded with the first pad PD1, the second pad PD2, the third pad PD3 and the common pad CPD, respectively, may be formed on the mounting board MB Adhesion balls BL may be respectively formed on the bonding pads BPD. Each of the adhesion balls BL may include In, Au, Sn, Cu, and the like. Unlike this, adhesion balls BL may be formed on the first pad PD1, the second pad PD2, the third pad PD3 and the common pad CPD.

The bonding pads BPD and the adhesion balls BL may be formed to correspond to positions where the light emitting devices LED are to be mounted.

By turning over the first substrate 100 which is formed with the plurality of light emitting devices LED, the light emitting devices LED may be positioned to face the mounting board MB which is formed with the bonding pads BPD.

A mask pattern MSK having a hole which allows laser pass therethrough and is disposed at a position corresponding to the light emitting devices LED to be separated from the first substrate 100 may be provided on the turned-over first substrate 100. The mask pattern MSK amy be omitted.

Referring to FIG. 18, by performing a selective laser lift-off (LLO) process for the first substrate 100 through using the mask pattern MSK, the light emitting devices LED which are disposed to face target mounting positions of the mounting board MB may be separated from the first substrate 100. A separation distance between the separated light emitting devices LED may be changed depending on the mounting board MB. When the light emitting devices LED are separated from the first substrate 100 by irradiating a laser onto the first substrate 100, a mask pattern MSK is provided on the first substrate 100, thereby more precise irradiation of the laser may be performed on the light emitting devices LEDs to be separated from the 100. However, if the laser can be properly irradiated to the light emitting devices LEDs to be separated, the mask pattern MSK may be omitted.

The first pad PD1, the second pad PD2, the third pad PD3 and the common pad CPD of each of the separated light emitting devices LED may be respectively bonded with the adhesion balls BL which are formed on the bonding pads BPD. By this fact, the light emitting devices LED may be mounted to the mounting board MB

If all the light emitting devices LED are mounted at the target positions, the first substrate 100 may be separated from the light emitting devices LED without separately performing a process for removing the first substrate 100.

While various embodiments have been described above, it will be understood to those skilled in the art that the embodiments described are by way of example only. Accordingly, the disclosure described herein should not be limited based on the described embodiments.

## Claims

1. A light emitting device comprising:
a first light emitting part including a first first-type semiconductor layer, a first active layer and a first second-type semiconductor layer;
a second light emitting part disposed over the first light emitting part, and including a second first-type semiconductor layer, a second active layer and a second second-type semiconductor layer;
a third light emitting part disposed over the second light emitting part, and including a third first-type semiconductor layer, a third active layer and a third second-type semiconductor layer;
a first conductive pattern including a first portion which is disposed in the second light emitting part and is electrically coupled with at least one among the first first-type, first second-type, second first-type and second second-type semiconductor layers, and a second portion which extends from the first portion to one surface of the second light emitting part between the second and third light emitting parts; and
a second conductive pattern disposed on the third light emitting part, and electrically coupled with the first conductive pattern,
wherein the second conductive pattern includes an area which overlaps at least partially with the second portion of the first conductive pattern.

2. The light emitting device according to claim 1,
wherein the second light emitting part has a via hole passing through at least a portion of the second light emitting part, and
wherein the first portion of the first conductive pattern is formed along the via hole, and an inside of the via hole is filled with an insulating material.

3. The light emitting device according to claim 2,
wherein the third light emitting part has a via hole passing through the third light emitting part,
wherein the second conductive pattern includes a first portion which is formed along the via hole of the third light emitting part, and a second portion which extends from the first portion to one surface of the third light emitting part, and
wherein the second portion of the first conductive pattern and the first portion of the second conductive pattern partially overlap with each other.

4. The light emitting device according to claim 3, wherein the first portion of the first conductive pattern and the first portion of the second conductive pattern have the same width.

5. The light emitting device according to claim 3, further comprising:
a pad electrically coupled with the second portion of the second conductive pattern.

6. The light emitting device according to claim 1,
wherein the second light emitting part has a via hole passing through at least a portion of the second light emitting part, and
wherein the first portion of the first conductive pattern fills the via hole.

7. The light emitting device according to claim 6,
wherein the third light emitting part has a via hole passing through the third light emitting part,
wherein the second conductive pattern includes a first portion which fills the via hole of the third light emitting part, and a second portion which extends from the first portion onto one surface of the third light emitting part, and
wherein the second portion of the first conductive pattern and the first portion of the second conductive pattern include at least partial areas which overlap with each other.

8. The light emitting device according to claim 7, wherein the first portion of the first conductive pattern and the first portion of the second conductive pattern have the same width.

9. The light emitting device according to claim 7, further comprising:
a pad electrically coupled with the second portion of the second conductive pattern.

10. The light emitting device according to claim 1,
wherein the first portion of the first conductive pattern is electrically coupled with the first first-type semiconductor layer, and the second portion is electrically coupled with the second first-type semiconductor layer on the one surface of the second light emitting part, and
wherein the second conductive pattern includes a first portion which is electrically coupled with the second portion of the first conductive pattern, and a second portion which extends from the first portion of the second conductive pattern and is electrically coupled with the third first-type semiconductor layer.

11. The light emitting device according to claim 1,
wherein the first portion of the first conductive pattern is electrically coupled with the first second-type semiconductor layer, and
wherein the second conductive pattern includes a first portion which is electrically coupled with the second portion of the first conductive pattern, and a second portion which extends from the first portion of the second conductive pattern to one surface of the third light emitting part.

12. The light emitting device according to claim 1,
wherein the first portion of the first conductive pattern is electrically coupled with the second second-type semiconductor layer, and
wherein the second conductive pattern includes a first portion which is electrically coupled with the second portion of the first conductive pattern, and a second portion which extends from the first portion of the second conductive pattern to one surface of the third light emitting part.

13. The light emitting device according to claim 1, further comprising: a third conductive pattern electrically coupled with the third second-type semiconductor layer.

14. The light emitting device according to claim 13,
wherein the third light emitting part has a via hole passing through at least a portion of the third light emitting part, and
wherein the third conductive pattern includes a first portion which is disposed along the via hole, and a second portion which extends from the first portion to one surface of the third light emitting part.

15. The light emitting device according to claim 14, further comprising:
a pad electrically coupled with the second portion of the third conductive pattern.

16. The light emitting device according to claim 13,
wherein the third light emitting part has a via hole passing through at least a portion of the third light emitting part, and
wherein the third conductive pattern includes a first portion which fills the via hole, and a second portion which extends from the first portion to one surface of the third light emitting part.

17. The light emitting device according to claim 1, wherein each of the first to third light emitting parts has an inclined outer sidewall.

18. The light emitting device according to claim 1, further comprising:
an insulating layer disposed between the first portion of the first conductive pattern and a side surface of the second light emitting part.

19. The light emitting device according to claim 18, wherein the insulating layer extends to an outer sidewall of the second light emitting part.

20. The light emitting device according to claim 1, further comprising:
a first adhesion part bonding the first and second light emitting parts; and
a second adhesion part bonding the second and third light emitting parts,
wherein the first adhesion part extends to an outer sidewall of the first light emitting part, and
wherein the second adhesion part extends to an outer sidewall of the second light emitting part.

21. The light emitting device according to claim 20, further comprising:
an insulating layer extending to an outer sidewall of the first portion of the first conductive pattern and an outer sidewall of the second light emitting part,
wherein the insulating layer is disposed between the second light emitting part and the second adhesion part.

22. The light emitting device according to claim 20,
wherein each of the first and second light emitting parts has an inclined outer sidewall,
wherein the first adhesion part has a width that increases from the first light emitting part toward the second light emitting part, and
wherein the second adhesion part has a width that increases from the second light emitting part toward the third light emitting part.
